# EUROPEAN PATENT SPECIFICATION

(11) **EP 1 493 309 B1**
(45) Date of publication and mention of the grant of the patent: **22.03.2006**
(21) Application number: 03722550.5
(22) Date of filing: 08.04.2003
(51) Int. Cl.: H05H 1/24

(54) **AN ATMOSPHERIC PRESSURE PLASMA ASSEMBLY**
ATMOSPHÄRENDRUCK-PLASMAVORRICHTUNG
ENSEMBLE DE PRODUCTION DE PLASMA A PRESSION ATMOSPHERIQUE

(30) Priority: 10.04.2002 GB 0208261
(43) Date of publication of application: 05.01.2005
(73) Proprietor: Dow Corning Ireland Limited, Midleton, County Cork (IE)
(72) Inventor: GOODWIN, Andrew James, Douglas, County Cork (IE); LEADLEY, Stuart, Midleton, County Cork (IE); SWALLOW, Frank, Cobh, County Cork (IE); DOBBYN, Peter, Middleton, County Cork (IE)
(74) Representative: Donlan, Andrew Michael
(86) International application number: PCT/EP2003/004349
(87) International publication number: WO 2003/086031

(56) References cited:
- WO-A-01/59809
- WO-A-02/28548
- WO-A-02/35576
- US-A- 5 529 631
- US-A- 5 939 151
- US-A- 6 013 337

## Description

The present invention relates to an atmospheric pressure plasma assembly and a method of treating a substrate using said assembly.

When matter is continually supplied with energy, its temperature increases and it typically transforms from a solid to a liquid and, then, to a gaseous state. Continuing to supply energy causes the system to undergo yet a further change of state in which neutral atoms or molecules of the gas are broken up by energetic collisions to produce negatively charged electrons, positive or negatively charged ions and other species. This mix of charged particles exhibiting collective behaviour is called "plasma", the fourth state of matter. Due to their electrical charge, plasmas are highly influenced by external electromagnetic fields, which makes them readily controllable. Furthermore, their high energy content allows them to achieve processes which are impossible or difficult through the other states of matter, such as by liquid or gas processing.

The term "plasma" covers a huge range of systems whose density and temperature vary by many orders of magnitude. Some plasmas are very hot and all their microscopic species (ions, electrons, etc.) are in approximate thermal equilibrium, the energy input into the system being widely distributed through atomic/molecular level collisions. Other plasmas, however, particular those at low pressure (e.g. 100 Pa) where collisions are relatively infrequent, have their constituent species at widely different temperatures and are called "non-thermal equilibrium" plasmas. In these non-thermal plasmas the free electrons are very hot with temperatures of many thousands of Kelvin (K) whilst the neutral and ionic species remain cool. Because the free electrons have almost negligible mass, the total system heat content is low and the plasma operates close to room temperature thus allowing the processing of temperature sensitive materials, such as plastics or polymers, without imposing a damaging thermal burden onto the sample. However, the hot electrons create, through high energy collisions, a rich source of radicals and excited species with a high chemical potential energy capable of profound chemical and physical reactivity. It is this combination of low temperature operation plus high reactivity which makes non-thermal plasma technologically important and a very powerful tool for manufacturing and material processing, capable of achieving processes which, if achievable at all without plasma, would require very high temperatures or noxious and aggressive chemicals.

For industrial applications of plasma technology, a convenient method is to couple electromagnetic power into a volume of process gas, which can be mixtures of gases and vapours in which the workpieces/samples to be treated are immersed or passed through. The gas becomes ionised into plasma, generating chemical radicals, UV-radiation, and ions, which react with the surface of the samples. By correct selection of process gas composition, driving power frequency, power coupling mode, pressure and other control parameters, the plasma process can be tailored to the specific application required by a manufacturer.

Because of the huge chemical and thermal range of plasmas, they are suitable for many technological applications. Non-thermal equilibrium plasmas are particularly effective for surface activation, surface cleaning, material etching and coating of surfaces.

The surface activation of polymeric materials is a widely used industrial plasma technology pioneered by the automotive industry. Thus, for example, polyolefins, such as polyethylene and polypropylene, which are favoured for their recylability, have a non-polar surface and consequently a poor disposition to coating or gluing. However, treatment by oxygen plasma results in the formation of surface polar groups giving high wettability and consequently excellent coverage and adhesion to metal paints, adhesives or other coatings. Thus, for example, plasma surface engineering is becoming increasingly important in the manufacture of vehicle fascias, dashboards, bumpers and the like as well as in component assembly in the toy and like industries. Many other applications are available in the printing, painting, gluing, laminating and general coating of components of all geometries in polymer, plastic, ceramic/inorganic, metal and other materials.

The increasing pervasiveness and strength of environmental legislation worldwide is creating substantial pressure on industry to reduce or eliminate the use of solvents and other wet chemicals in manufacturing, particularly for component/surface cleaning. In particular, CFC-based degreasing operations have been largely replaced by plasma cleaning technology operating with oxygen, air and other non-toxic gases. Combining water based precleaning operations with plasma allows even heavily soiled components to be cleaned; the resulting surface qualities obtained being generally superior to those resulting from traditional methods. Any organic surface contamination is rapidly scavenged by room temperature plasma and converted to gaseous CO₂ and water, which can be safely exhausted.

Plasmas can also carry out etching of a bulk material, i.e. for the removal of unwanted material therefrom. Thus, for example, an oxygen based plasma will etch polymers, a process used in the production of circuit boards, etc. Different materials such as metals, ceramics and inorganics are etched by careful selection of precursor gas and attention to the plasma chemistry. Structures down to nanometer critical dimensions are now being produced by plasma etching technology.

A plasma technology that is rapidly emerging into mainstream industry is that of plasma coating/thin film deposition. Typically, a high level of polymerisation is achieved by application of plasma to monomeric gases and vapours. Thus, a dense, tightly knit and three-dimensionally connected film can be formed which is thermally stable, chemically very resistant and mechanically robust. Such films are deposited conformally on even the most intricate of surfaces and at a temperature which ensures a low thermal burden on the substrate. Plasmas are therefore ideal for the coating of delicate and heat sensitive, as well as robust materials. Plasma coatings are free of micropores even with thin layers. The optical properties, e.g. colour, of the coating can often be customised and plasma coatings adhere well to even non-polar materials, e.g. polyethylene, as well as steel (e.g. anti-corrosion films on metal reflectors), ceramics, semiconductors, textiles, etc.

In all these processes, plasma engineering produces a surface effect customised to the desired application or product without affecting the material bulk in any way. Plasma processing thus offers the manufacturer a versatile and powerful tool allowing choice of a material for its bulk technical and commercial properties while giving the freedom to independently engineer its surface to meet a totally different set of needs. Plasma technology thus confers greatly enhanced product functionality, performance, lifetime and quality and gives the manufacturing company significant added value to its production capability.

These properties provide a strong motivation for industry to adopt plasma-based processing, and this move has been led since the 1960s by the microelectronics community which has developed the low pressure Glow Discharge plasma into an ultra-high technology and high capital cost engineering tool for semiconductor, metal and dielectric processing. The same low pressure Glow Discharge type plasma has increasingly penetrated other industrial sectors since the 1980s offering, at more moderate cost, processes such as polymer surface activation for increased adhesion/bond strength, high quality degreasing/cleaning and the deposition of high performance coatings. Thus, there has been a substantial take-up of plasma technology. Glow discharges can be achieved at both vacuum and atmospheric pressures. In the case of atmospheric pressure glow discharge, gases such as helium or argon are utilised as diluents and a high frequency (e.g.> 1kHz) power supply is used to generate a homogeneous glow discharge at atmospheric pressure via a Penning ionisation mechanism, (see for example, Kanazawa et al, J.Phys. D: Appl. Phys. 1988, 21, 838, Okazaki et al, Proc. Jpn. Symp. Plasma Chem. 1989, 2, 95, Kanazawa et al, Nuclear Instruments and Methods in Physical Research 1989, B37/38, 842, and Yokoyama et al., J. Phys. D: Appl. Phys. 1990, 23 374).

However, adoption of plasma technology has been limited by a major constraint on most industrial plasma systems, namely, their need to operate at low pressure. Partial vacuum operation means a closed perimeter, sealed reactor system providing only off-line, batch processing of discrete workpieces. Throughput is low or moderate and the need for vacuum adds capital and running costs.

Atmospheric pressure plasmas, however, offer industry open port or perimeter systems providing free ingress into and exit from the plasma region by workpieces/webs and, hence, on-line, continuous processing of large or small area webs or conveyor-carried discrete workpieces. Throughput is high, reinforced by the high species flux obtained from high pressure operation. Many industrial sectors, such as textiles, packaging, paper, medical, automotive, aerospace, etc., rely almost entirely upon continuous, on-line processing so that open port/perimeter configuration plasmas at atmospheric pressure offer a new industrial processing capability.

Corona and flame (also a plasma) treatment systems have provided industry with a limited form of atmospheric pressure plasma processing capability for about 30 years. However, despite their high manufacturability, these systems have failed to penetrate the market or be taken up by industry to anything like the same extent as the lower pressure, bath-processing-only plasma type. The reason is that corona/flame systems have significant limitations. They operate in ambient air offering a single surface activation process and have a negligible effect on many materials and a weak effect on most. The treatment is often nonuniform and the corona process is incompatible with thick webs or 3D workpieces while the flame process is incompatible with heat sensitive substrates.

Significant advances have been made in plasma treatment at atmospheric pressure. Considerable work has been done on the stabilisation of atmospheric pressure glow discharges, such as in Okazaki et al., J. Phys. D: Appl. Phys. 26 (1993) 889-892. Further, there is described in US Patent Specification No. 5414324 (Roth et al) the generation of a steady-state glow discharge plasma at atmospheric pressure between a pair of insulated metal plate electrodes spaced up to 5 cm apart and radio frequency (RF) energised with a root mean square (rms) potential of 1 to 5 kV at 1 to 100 kHz. This patent specification describes the use of electrically insulated metallic plate electrodes and also the problems of electrode plates and the need to discourage electrical breakdown at the edge of electrodes. It further describes the use of the electrodes, which in this case are copper plates, and a water cooling system, which is supplied through fluid flow conduits bonded to the electrodes and as such, water does not come into direct contact with any electrode surface.

In US Patent Specification No. 5185132, (Horiike et al), there is described an atmospheric plasma reaction method in which plate electrodes are used in a vertical configuration. However, they are merely used in the vertical configuration to prepare the plasma and then the plasma is directed out from between the plates onto a horizontal surface below the vertically arranged electrodes and downstream from the plasma source.

In EP 0809275 and JP 11-29873 there are provided atmospheric pressure glow discharge systems having at least two sets of horizontally arrayed pairs of electrodes through which a substrate web may be passed continuously by means of rollers. JP 11-241165 and JP 2000-212753 describe electric discharge type plasma system using pulsed electric fields. In all four of these documents the substrate is treated with gases.

In the applicants co-pending application WO 02/35576, which was published after the priority date of the present application, a plasma system of the type comprising a pair of parallel spaced-apart planar electrodes with at least one dielectric plate therebetween and adjacent one electrode, the spacing between the dielectric plate and the other dielectric plate or electrodes forming a plasma region for a precursor gas wherein a cooling liquid distribution system is provided for directing a cooling conductive liquid onto the exterior of at least one of the electrodes to cover a planar face of the at least one electrode.
WO-01/59809 discloses an atmosphere pressure plasma assembly in accordance with the preamble of claim 1.
In US-6013337 and US-5939151 the use of atomisers is described.

According to the present invention there is provided an atmospheric pressure plasma assembly as defined in claim 1 and a method of treating a substrate using said assembly as defined in claim 12.

The terms "comprise, comprises, comprised and comprising" or any variation thereof and the terms "include, includes, included and including" or any variation thereof are considered to be totally interchangeable and they should all be afforded the widest possible interpretation.

It should be understood that the term vertical is intended to include substantially vertical and should not be restricted solely to electrodes positioned at 90 degrees to the horizontal.

Preferably the means of transporting the substrate is by a reel to reel based process. The substrate may be transported through the first plasma region in an upwardly or downwardly direction. Preferably when the substrate passes through one plasma zone in an upwardly direction and the other in a downwardly direction one or more guide rollers are provided to guide the substrate from the end of the first reel into the first plasma zone, from the first plasma zone to and into the second plasma zone and from the second plasma zone to the second reel or next plasma zone dependent on the number of plasma zones being used. The substrate residence time in each plasma region may be predetermined prior to coating and rather than varying the speed of the substrate, through each plasma zone, the path length a substrate has to travel through each plasma region may be altered such that the substrate may pass through both regions at the same speed but may spend a different period of time in each plasma region due to differing path lengths through the respective plasma regions.

In view of the fact that the electrodes in the present invention are vertically orientated it is preferred that a substrate be transported through an atmospheric pressure plasma assembly in accordance with the present invention upwardly through one plasma region and downwardly though the other plasma region. On the basis of the distance between adjacent electrodes, as will be discussed below, it will be appreciated that the substrate is generally transported through a plasma region in a vertical or diagonal direction although in most cases it will be vertical or substantially vertical.

Preferably each substrate needs only to be subjected to one pass through the assembly but if required the substrate may be returned to the first reel for further passages through the assembly.

Additional pairs of electrodes may be added to the system to form further successive plasma regions through which a substrate would pass. The additional pairs of electrodes may be situated before or after said first and second pair of electrodes such that substrate would be subjected to pre-treatment or post-treatment steps. Said additional pairs of electrodes are preferably situated before or after and most preferably after said first and second pairs of electrodes. Treatments applied in the plasma regions formed by the additional pairs of electrodes may be the same or different from that undertaken in the first and second plasma regions. In the case when additional plasma regions are provided for pre-treatment or post-treatment the necessary number of guides and/or rollers will be provided in order to ensure the passage of the substrate through the assembly. Similarly preferably the substrate will be transported alternatively upwardly and downwardly through all neighbouring plasma regions in the assembly.

Each electrode may comprise any suitable geometry and construction. Metal electrodes may be used and may be in for example the form of metallic plates or a mesh. The metal electrodes may be bonded to the dielectric material either by adhesive or by some application of heat and fusion of the metal of the electrode to the dielectric material. Alternatively one or more of the electrodes may be encapsulated within the dielectric material or may be in the form of a dielectric material with a metallic coating such as, for example a dielectric, preferably a glass dielectric with a sputtered metallic coating.

In one embodiment of the invention each electrode is of the type described in the applicants co-pending application WO 02/35576 wherein there are provided electrode units containing an electrode and an adjacent a dielectric plate and a cooling liquid distribution system for directing a cooling conductive liquid onto the exterior of the electrode to cover a planar face of the electrode. Each electrode unit may comprise a watertight box having a side formed by a dielectric plate having bonded thereto on the interior of the box the planar electrode together with a liquid inlet and a liquid outlet. The liquid distribution system may comprise a cooler and a recirculation pump and/or a sparge pipe incorporating spray nozzles.

Ideally the cooling liquid covers the face of the electrode remote from the dielectric plate. The cooling conductive liquid is preferably water and may contain conductivity controlling compounds such as metal salts or soluble organic additives. Ideally, the electrode is a metal electrode in contact with the dielectric plate. In one embodiment, there is a pair of metal electrodes each in contact with a dielectric plate. The water in accordance with the present invention acts as well as being an extremely efficient cooling agent to also assist in providing an efficient electrode.

Ideally the dielectric plate extends beyond the perimeter of the electrode and the cooling liquid is also directed across the dielectric plate to cover at least that portion of dielectric bordering the periphery of the electrode. Preferably, all the dielectric plate is covered with cooling liquid. The electrode may be in the form of a metal mesh. The water also acts to electrically passivate any boundaries, singularities or non-uniformity in the metal electrodes such as edges, corners or mesh ends where the wire mesh electrodes are used. Effectively the water acts as an electrode of limited conductivity. Further, by having a vertical arrangement, the weight of large areas of electric systems are now placed so that there is not the same sag or distortion or deformation that there might otherwise be.

The assembly is preferably retained in an outer casing as defined in the applicant's co-pending application WO 01/59809 in which a lid is provided to prevent escape of a process gas, which is required in order to activate the plasma. The lid may be situated on top of the outer casing, i.e. covering the top of all the electrodes or may be situated at the bottom of the casing, i.e. covering the base of all the electrodes, dependent on whether the process gas used is lighter or heavier than air (e.g. helium and argon respectively).

The dielectric materials used in accordance with the present invention may be made from any suitable dielectric, examples include but are not restricted to polycarbonate, polyethylene, glass, glass laminates, epoxy filled glass laminates and the like.

The process gas for use in plasma treatment processes using the electrodes of the present invention may be any suitable gas but is preferably an inert gas or inert gas based mixture such as, for example helium, a mixture of helium and argon and an argon based mixture additionally containing ketones and/or related compounds. These process gases may be utilized alone or in combination with potentially reactive gases such as, for example, nitrogen, ammonia, O₂, H₂O, NO₂, air or hydrogen. Most preferably, the process gas will be Helium alone or in combination with an oxidizing or reducing gas. The selection of gas depends upon the plasma processes to be undertaken. When an oxidizing or reducing process gas is required, it will preferably be utilized in a mixture comprising 90 - 99% noble gas and 1 to 10% oxidizing or reducing gas.

Under oxidising conditions the present method may be used to form an oxygen containing coating on the substrate. For example, silica-based coatings can be formed on the substrate surface from atomised silicon-containing coating-forming materials. Under reducing conditions, the present method may be used to form oxygen free coatings, for example, silicon carbide based coatings may be formed from atomised silicon containing coating forming materials.

In a nitrogen containing atmosphere nitrogen can bind to the substrate surface, and in an atmosphere containing both nitrogen and oxygen, nitrates can bind to and/or form on the substrate surface. Such gases may also be used to pre-treat the substrate surface prior to exposure to a coating forming substance. For example, oxygen containing plasma treatment of the substrate may provide improved adhesion with the applied coating. The oxygen containing plasma being generated by introducing oxygen containing materials to the plasma such as oxygen gas or water.

A wide variety of plasma treatments are currently available, those of particular importance to the present invention are surface activation, surface cleaning and coating applications. Typically the substrate may be subjected to any appropriate treatment for example whilst passing through the first plasma region a substrate might be cleaned and when passing through the second plasma region the substrate might be surface activated, coated or etched and in the case when further plasma regions are provided after the first and second plasma regions said additional plasma regions may, when the second plasma region is utilised to activate a surface, further activate the surface, or apply a coating and when the second plasma region is utilised to coat the substrate surface, the additional plasma regions might be utilised to activated the coated surface and then re-coat the surface, apply a one or more further coatings or the like, dependent on the application for which the substrate is intended. For example, a coating formed on a substrate may be post treated in a range of plasma conditions. For example, siloxane derived coatings may be further oxidised by oxygen containing plasma treatment. The oxygen containing plasma being generated by introducing oxygen containing materials to the plasma such as oxygen gas or water.

Any appropriate combination of plasma treatments may be used, for example the first plasma region may be utilised to clean the surface of the substrate by plasma treating using a helium gas plasma and the second plasma region is utilised to apply a coating, for example, by application of a liquid or solid spray through an atomiser or nebuliser as described in the applicants co-pending application WO 02/28548, which was published after the priority date of this application. The application of a coating of a liquid spray is particularly suited as the droplets in the spray will be subjected to gravitational feed unlike a gas such that the nebuliser is positioned in the assembly such that gravity feed of the coating material results in the coating precursor only passing through the second plasma region, thereby relying on gravity to prevent transfer of coating precursor into the first plasma region.

Alternatively the first plasma region might be utilised as a means of oxidation (in for example, an oxygen/Helium process gas) or the application of coating and the second plasma region is utilised to apply a second coating using a different precursor. As an example having a pre-treatment and post-treatment step is the following process adapted for the preparation of a SiOx barrier with a soil/fuel resistant outer surface which may be utilised for solar cells or in auto applications in which the substrate is first pretreated by He cleaning/activation of substrate, followed by deposition of SiOx from a polydimethylsiloxane precursor in the first plasma region. Further Helium plasma treatment to provide extra crosslinking of the SiOx layer and finally applying a coating utilizing a perfluorinated precursor. Any appropriate pre-treatments may be undertaken for example the substrate may be washed, dried, cleaned or gas purged using the process gas, for example helium.

The coating-forming material may be atomised using any conventional means, for example an ultrasonic nozzle. The atomiser preferably produces a coating-forming material drop size of from 10 to 100µm, more preferably from 10 to 50µm. Suitable atomisers for use in the present invention are ultrasonic nozzles from Sono-Tek Corporation, Milton, New York, USA or Lechler GmbH of Metzingen Germany. The apparatus of the present invention may include a plurality of atomisers, which may be of particular utility, for example, where the apparatus is to be used to form a copolymer coating on a substrate from two different coating-forming materials, where the monomers are immiscible or are in different phases, e.g. the first is a solid and the second is gaseous or liquid.

The present invention may be used to form many different types of substrate coatings. The type of coating which is formed on the substrate is determined by the coating-forming material(s) used, and the present method may be used to (co)polymerise coating-forming monomer material(s) onto the substrate surface. The coating-forming material may be organic or inorganic, solid, liquid or gaseous, or mixtures thereof. Suitable organic coating-forming materials include carboxylates, methacrylates, acrylates, styrenes, methacrylonitriles, alkenes and dienes, for example methyl methacrylate, ethyl methacrylate, propyl methacrylate, butyl methacrylate, and other alkyl methacrylates, and the corresponding acrylates, including organofunctional methacrylates and acrylates, including glycidyl methacrylate, trimethoxysilyl propyl methacrylate, allyl methacrylate, hydroxyethyl methacrylate, hydroxypropyl methacrylate, dialkylaminoalkyl methacrylates, and fluoroalkyl (meth)acrylates, methacrylic acid, acrylic acid, fumaric acid and esters, itaconic acid (and esters), maleic anhydride, styrene, α-methylstyrene, halogenated alkenes, for example, vinyl halides, such as vinyl chlorides and vinyl fluorides, and fluorinated alkenes, for example perfluoroalkenes, acrylonitrile, methacrylonitrile, ethylene, propylene, allyl amine, vinylidene halides, butadienes, acrylamide, such as N-isopropylacrylamide, methacrylamide, epoxy compounds, for example glycidoxypropyltrimethoxysilane, glycidol, styrene oxide, butadiene monoxide, ethyleneglycol diglycidylether, glycidyl methacrylate, bisphenol A diglycidylether (and its oligomers), vinylcyclohexene oxide, conducting polymers such as pyrrole and thiophene and their derivatives, and phosphorus-containing compounds, for example dimethylallylphosphonate. Suitable inorganic coating-forming materials include metals and metal oxides, including colloidal metals. Organometallic compounds may also be suitable coating-forming materials, including metal alkoxides such as titanates, tin alkoxides, zirconates and alkoxides of germanium and erbium.

Substrates may alternatively be provided with silica- or siloxane-based coatings using coating-forming compositions comprising silicon-containing materials. Suitable silicon-containing materials include silanes (for example, silane, alkylsilanes alkylhalosilanes, alkoxysilanes) and linear (for example, polydimethylsiloxane) and cyclic siloxanes (for example, octamethylcyclotetrasiloxane), including organo-functional linear and cyclic siloxanes (for example, Si-H containing, halo-functional, and haloalkyl-functional linear and cyclic siloxanes, e.g. tetramethylcyclotetrasiloxane and tri(nonofluorobutyl)trimethylcyclotrisiloxane). A mixture of different silicon-containing materials may be used, for example to tailor the physical properties of the substrate coating for a specified need (e.g. thermal properties, optical properties, such as refractive index, and viscoelastic properties).

An advantage of the present invention over the prior art is that both liquid and solid atomised coating-forming materials may be used to form substrate coatings, due to the method of the present invention taking place under conditions of atmospheric pressure. Furthermore the coating-forming materials can be introduced into the plasma discharge or resulting stream in the absence of a carrier gas, i.e. they can be introduced directly by, for example, direct injection, whereby the coating forming materials are injected directly into the plasma.

The substrate to be coated may comprise any material, sufficiently flexible to be transported through the assembly as hereinbefore described, for example plastics for example thermoplastics such as polyolefins e.g. polyethylene, and polypropylene, polycarbonates, polyurethanes, polyvinylchloride, polyesters (for example polyalkylene terephthalates, particularly polyethylene terephthalate), polymethacrylates (for example polymethylmethacrylate and polymers of hydroxyethylmethacrylate), polyepoxides, polysulphones, polyphenylenes, polyetherketones, polyimides, polyamides, polystyrenes, phenolic, epoxy and melamine-formaldehyde resins, and blends and copolymers thereof. Preferred organic polymeric materials are polyolefins, in particular polyethylene and polypropylene. Other substrates include metallic thin films made from e.g. aluminium, steel, stainless steel and copper or the like.

The substrate may be in the form of synthetic and/or natural fibres, woven or non-woven fibres, powder, siloxane, fabrics, cellulosic material and powder or a blend of an organic polymeric material and a organosilicon-containing additive which is miscible or substantially non-miscible with the organic polymeric material as described in the applicants co-pending patent application WO 01/40359. For the avoidance of doubt "substantially non-miscible" means that the organosilicon-containing additive and the organic material have sufficiently different interaction parameters so as to be non-miscible in equilibrium conditions. This will typically, but not exclusively, be the case when the Solubility Parameters of the organosilicon-containing additive and the organic material differ by more than 0.5 MPa^{1/2}. However, the size of the substrate is limited by the dimensions of the volume within which the atmospheric pressure plasma discharge is generated, i.e. the distance between the electrodes of the means for generating the plasma.

In one particularly preferred embodiment of the invention there is provided an atmospheric plasma assembly for preparing multilayer coatings upon flexible substrates. The plasma is generated by vertically orientated electrodes, which can be arranged in series, enabling single pass, multiple treatment or multilayer coating. Coating forming material or coating precursor is introduced as an atomised liquid into the top of the chamber, the precursor then enters the plasma zone under gravity. Advantages are that the different plasma zones require no physical barrier separation, and each operates as an open perimeter process.

For typical plasma generating apparatus, the plasma is generated within a gap of from 3 to 50mm, for example 5 to 25mm. Thus, the present invention has particular utility for coating films, fibres and powders. The generation of steady-state glow discharge plasma at atmospheric pressure is preferably obtained between adjacent electrodes which may be spaced up to 5 cm apart, dependent on the process gas used. The electrodes being radio frequency energised with a root mean square (rms) potential of 1 to 100 kV, preferably between 1 and 30 kV at 1 to 100 kHz, preferably at 15 to 50 kHz. The voltage used to form the plasma will typically be between 1 and 30 kVolts, most preferably between 2.5 and 10 kV however the actual value will depend on the chemistry/gas choice and plasma region size between the electrodes. Whilst the atmospheric pressure glow discharge assembly may operate at any suitable temperature, it preferably will operate at a temperature between room temperature (20° C) and 70° C and is typically utilized at a temperature in the region of 30 to 50°C.

Substrates coated by the method of the present invention may have various uses. For example, a silica-based coating, generated in an oxidising atmosphere, may enhance the barrier and/or diffusion properties of the substrate, and may enhance the ability of additional materials to adhere to the substrate surface. A halo-functional organic or siloxane coating (e.g. perfluoroalkenes) may increase hydrophobicity, oleophobicity, fuel and soil resistance, enhance gas and liquid filtration properties and/or the release properties of the substrate. A polydimethylsiloxane coating may enhance water resistance and release properties of the substrate, and may enhance the softness of fabrics to touch; a polyacrylic acid polymeric coating may be used as a water wettable coating, bio-compatible coating or an adhesive layer to promote adhesion to substrate surface or as part of laminated structure. The inclusion of colloidal metal species in the coatings may provide surface conductivity to the substrate, or enhance its optical properties. Polythiophene and polypyrrole give electrically conductive polymeric coatings which may also provide corrosion resistance on metallic substrates. Acidic or basic functionality coatings will provide surfaces with controlled pH, and controlled interaction with biologically important molecules such as amino acids and proteins.

The invention will be more clearly understood from the following description of some embodiments thereof given by way of example only with reference to the accompanying drawings, in which:-
Fig. 1 is a front view of an atmospheric pressure plasma system according to the invention,
Fig. 2 is a partially exploded perspective view of portion of the system illustrated in Fig. 1,
Fig. 3 is a plan view of the plasma assembly in accordance with the present invention
Fig. 4a and 4b are views of a further plasma assembly in accordance with the present invention

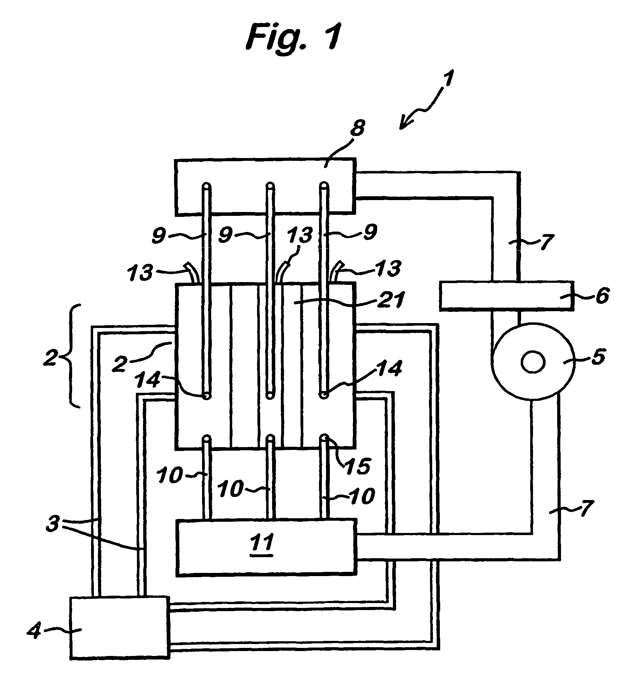

Referring to the drawings, In Fig. 1 there is provided an atmospheric plasma system, indicated generally by the reference numeral 1 comprising an atmospheric pressure plasma assembly 2 fed by cables 3 by a power source 4 and also fed by a cooling water assembly feeding a cooling liquid distribution system mounted within the plasma assembly 2 and described in more detail later. The cooling water assembly comprises a water pump 5, a cooler in the form of a heat exchanger 6 and main water distribution pipes 7. One of the main water distribution pipes 7 feeds an inlet manifold 8, which in turn feeds, through feed water hoses 9 and liquid inlets 14, into the plasma assembly 2. Return water hoses 10 connect through liquid outlets 15, to a further return output manifold 11, which in turn is connected to another of the water distribution pipes 7 which feeds the pump 5. Pressure release pipes 13 are mounted in the plasma assembly 2.

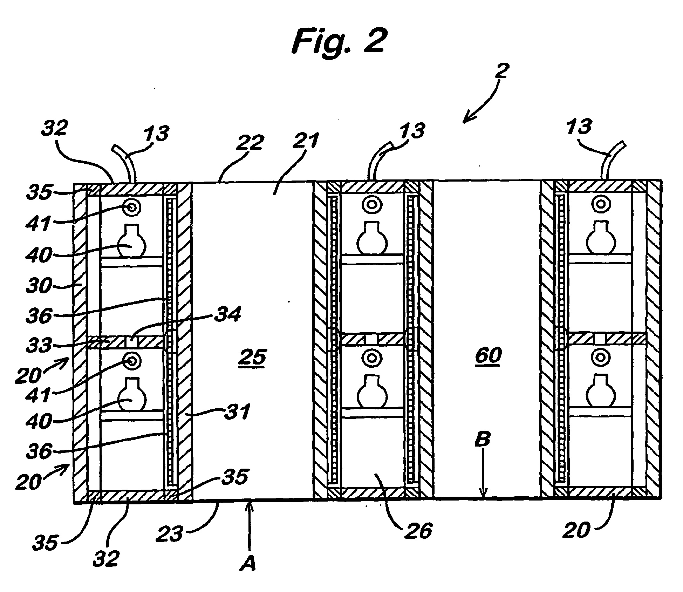

Referring now to Fig 2 in which there are provided three watertight boxes 20, 26. The watertight boxes indicated generally by the reference numeral 20 are joined by vertical insulated spacers in the form of spacer plates 21 which form between the watertight boxes 20 an open top 22 and an open bottom 23. Each watertight box 20 comprises a rear plate 30 and a spaced apart front plate 31 mounted on a water containment frame 32 having a crossbar 33 in which are provided drain-off holes 34. The rear plate 30 and the front plate 31 are connected to the water containment frame 32 by gaskets 35. Two sets of wire electrodes 36 are mounted in the box 20 on the front plate 31. The rear plate 30, front plate 31 and water containment frame 32 are manufactured of a suitable dielectric material. A pair of sparge poles 40 formed from pipes of an insulation material, such as a plastics material, carrying a plurality of nozzles 41 are mounted within the box 20 and are connected to the feed water hoses 9.

Between the watertight boxes 20 and the spacer plates 21, is a third watertight box 26 of substantially the same construction as the boxes 20, in which parts similar to those described for watertight box 20 below. The only difference between the box 26 and the box 20 is that it carries effectively two front plates 31 and carries electrodes 36 on each front plate 31 since the plates 31 act as front plates in respect of the boxes 20 on either side of the box 26. In this embodiment, the nozzles 41 of the sparge poles 40 direct water onto both plates 31.

In operation, a workpiece may be led up through plasma region 25 in the direction of the arrow A and then down through plasma region 60 in direction B. Process gas can be injected into the plasma regions 25, 60 and suitable power can be provided to the electrodes 36 in the plasma regions 25, 60 to affect a plasma. Water is delivered from the inlet manifold 8 through the feed water hoses 9 into the sparge poles 40 where the water is delivered in a spray out the nozzles 41 onto the wire electrodes 36 and also across the exposed interior face of the front plate 31.

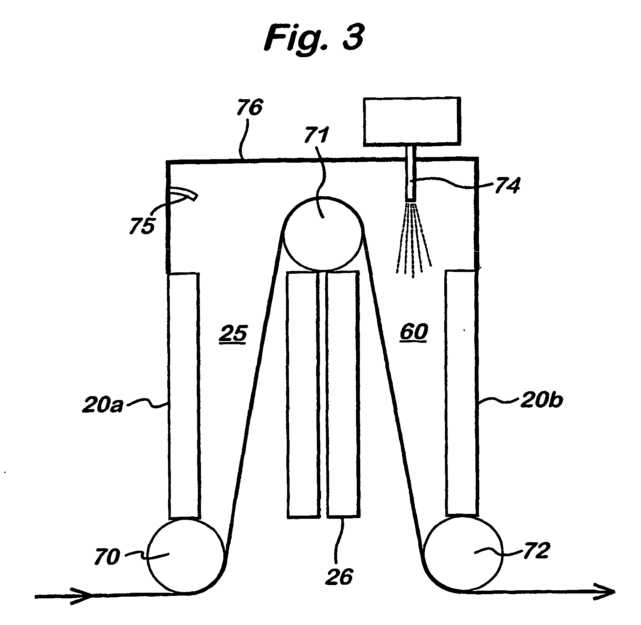

Referring now to Fig.3, there is provided a figure showing how a flexible substrate is treated in accordance with the present invention. A means of transporting a substrate through the assembly is provided in the form of guide rollers 70, 71 and 72, a process gas inlet 75, an assembly lid 76 and an ultrasonic nozzle 74 for introducing an atomised liquid into plasma region 60 are provided. The process gas inlet 75 may be found in the assembly lid 76 instead of the side as shown in Fig. 3)

In use a flexible substrate is transported to and over guide roller 70 and is thereby guided through plasma region 25 between watertight boxes 20a and 26. The plasma in the plasma region 25 is a cleaning helium plasma, i.e. no reactive agent is directed into plasma region 25. The helium is introduced into the system by way of inlet 75. Lid 76 is placed over the top of the system to prevent the escape of helium as it is lighter than air. Upon leaving plasma region 25 the plasma cleaned substrate passes over guide 71 and is directed down through plasma region 60, between electrodes 26 and 20b and over roller 72 and then may pass to further units of the same type for further treatment. However, plasma region 60 generates a coating for the substrate by means of the injection of a liquid or sold coating making material through ultrasonic nozzle 74. An important aspect of the fact that the reactive agent being coated is a liquid or solid is that said atomised liquid or solid travels under gravity through plasma region 60 and is kept separate from plasma region 25 and as such no coating occurs in plasma region 25. The coated substrate then passes through plasma region 60 and is coated and then is transported over roller 72 and is collected or further treated with additional plasma treatments. Rollers 70 and 72 may be reels as opposed to rollers. Having passed through is adapted to guide the substrate into plasma region25 and on to roller 71.

It has been found surprisingly that in addition to cooling, the water in accordance with the present invention, also acts to electrically passivate any boundaries, singularities or non-uniformities in the metal electrodes such as edges, corners or mesh ends where wire mesh electrodes are used. It will be appreciated that these, without passivation, can discharge a Corona or other plasma, causing power loss and local heating leading potentially to breakdown. Essentially, the water itself acts as an electrode of limited conductivity to smooth out potential differences and damp out unwanted electrical discharges inside the electrode box. Typically, the plasma generated in the inter-electrode gap will extend about 5 cm beyond the edge of the metal electrode due to water conductivity. Further, there are major advantages in longer residence time in the plasma region which allows the plasma to access all parts of a workpiece surface enhancing uniformity of treatment. This is particularly important with intricately formed workpieces. It has been found with the present invention that it is possible to maintain low electrode temperatures even with high plasma power densities ensuring long equipment lifetimes and elimination of excessive thermal burdens on the workpiece. Radio Frequency power was applied using a power supply to the electrodes via matching transformers at approximately 40 kHz and about 30 kW of RF power.

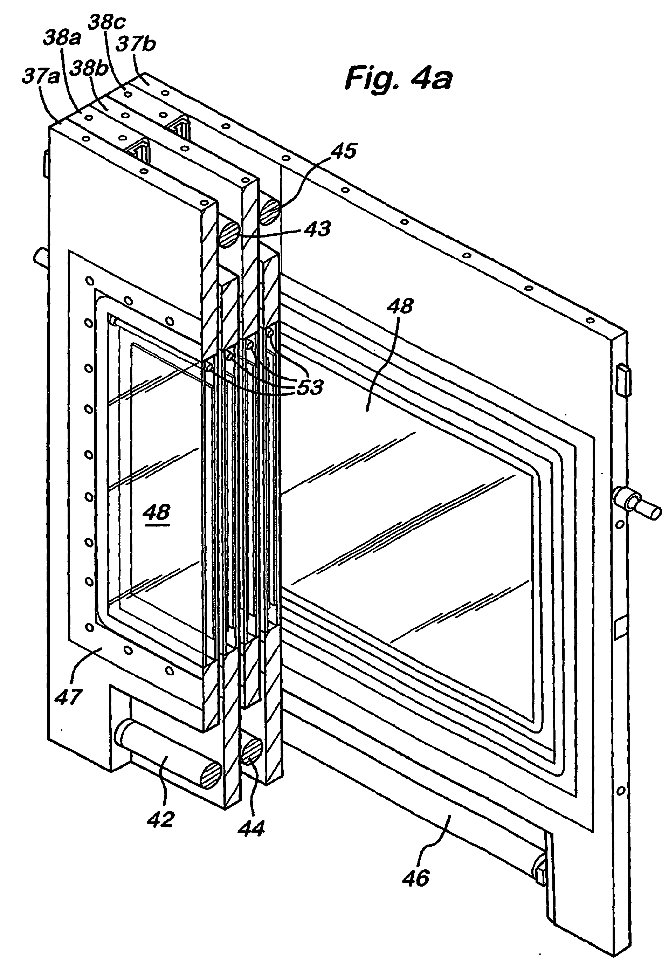

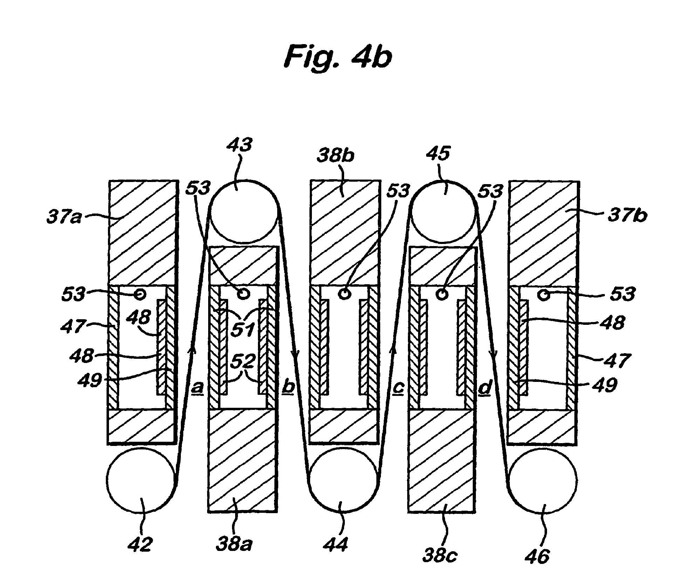

Figs.4a and 4b are intended to show an assembly in accordance with the present invention in which there are provided four plasma zones a, b, c and d. In this assembly, there are two types of watertight box electrodes used. Two single electrode boxes 37a and 37b are used at the exterior of the assembly and three double electrode watertight boxes 38 are provided for interior plasma regions as will be described below. Each watertight box 37 comprises a polypropylene body with an glass dielectric window 47 external to the systems and a second glass dielectric window 49 which forms one edge of a plasma zone (zones a and d in the present examples). Adhered to glass dielectric window 49 is a mesh electrode 48. A water inlet 53 is provided for provision of a means of spraying the mesh electrode 48. A water outlet is also provided for drainage purposes but is not shown.

Double electrodes 38a 38b and 38c are similar in construction to electrodes 37a and 37b, in that they comprise polypropylene bodies, and two glass dielectric windows 51, but have a mesh electrode 52 attached to both windows 51. Again, a water inlet 53 is provided for spraying water on both mesh electrodes 51.

Rollers and guides 42,43,44,45 and 46 are provided to guide the substrate through the plasma regions a, b, c and d respectively.

In use, a substrate is provided on roller 42 and is transported to roller 46 via the pathway identified by the arrows and dotted lines. The substrate travels upwardly from roller 42 to guide 43 through plasma region a formed between electrodes 37a and 38a. It then passes over guide 43 and into plasma region b between electrodes 38a and 38b to guide 44, upwardly to guide 45 and finally through plasma region d to roller 46. Typically plasma regions a and c are utilised for cleaning, the substrate, initially and after application of the first coating respectively and plasma regions b and d are utilised to for the applications of coatings using atomised liquid or solid coating forming materials in accordance with the process of the present invention via an atomiser (not shown). The atomiser is retained above the plasma regions b and d and relies upon gravity for the atomised liquid or solid to enter the its respective plasma region b and d. windows 47 49 and 51 are provided using glass to enable the operator to view the formation and operation of the plasma formed between the electrodes which is useful when problems within the assembly occur.

It is to be appreciated that any suitable electrode system within the scope of the present claims may be utilised and that the system described above is used merely for example.

### Example: Multilayer Coating on Polypropylene Film

As an example of the potential utility of the present invention there is provided the following example in which a 25 µm thick polypropylene film was coated twice using the apparatus in accordance with the present invention. The first coating was a hydrophilic polyacrylic acid coating, the second coating being an oleophobic and hydrophobic fluoropolymer coating. A KSV CAM200 Optical Contact Angle Meter was used to characterise
i) The untreated film which is hydrophobic but not oleophobic
ii) the acrylic acid treated film (i) and
iii) the fluoropolymer treated film (ii)
by sessile drop contact angle.
The untreated polypropylene film is hydrophobic but not oleophobic, as shown in Table 1. Note: The water contact angle indicates that this film is corona treated on receipt.

**Table 1: Contact Angle analysis of polypropylene film. (the term wets out is used to mean that no droplet formation is seen).**

| **Probe Liquid** | ***Θ (left)*** | ***Θ (right)*** |
|---|---|---|
| **Water** | 64.29 | 64.52 |
| **Water** | 62.99 | 61.37 |
| **Water** | 63.75 | 65.30 |
| **Hexadecane** | Wets out | Wets out |

The film is then coated using the described atmospheric pressure glow discharge (APGD) apparatus. The operating conditions used were the same for the application of both coatings Both pairs of electrodes used were made from a steel mesh and were adhered to a glass dielectric plate. The distance between the glass dielectric plates attached to the two electrodes was 6mm and the surface area thereof was (10cm x 60cm). The process gas used was helium. The plasma power to both zones 0.4kW, voltage was 4kV and the frequency was 29 kHz. The operating temperature was below 40° C. The substrate was passed through both the first and second plasma zones using a reel to reel mechanism of the type described in Fig.3 with a guide means being utilised to assist in the transport of the substrate out of the first and into the second plasma regions. The speed of the substrate passing through both plasma zones was 2m min⁻¹.

### Application of acrylic acid coating

The substrate was transported through a first plasma region in which it is activated by means of an atmospheric pressure glow discharge using helium as the process gas. Upon leaving the first plasma region the guide was utilised to direct the activated substrate into the second plasma zone into which an acrylic acid precursor is introduced via Sonotec ultrasonic nozzle into the coating zone at a rate of 50 µl min⁻¹. Contact angle analysis was undertaken on the resulting coated substrate and the results thereof are provided in Table 2 below. It will be noted that the hydrophilicity of the resulting coated substrate has significantly increased.

**Table 2: Contact Angle analysis of polypropylene film coated with polyacrylic acid**

| **Probe Liquid** | ***Θ (left)*** | ***Θ (right)*** |
|---|---|---|
| Water | 11.39 | 11.26 |
| Water | 11.18 | 11.51 |
| Water | 11.18 | 10.90 |
| Hexadecane | < 10 degrees | < 10 degrees |

### Application of Fluoropolymer

The second coating was applied in a similar fashion, with the first plasma zone being utilised to activate the surface and the second plasma zone being used to further coat the substrate with a layer of heptadecafluorodecyl acrylate. Contact angle analysis of the resulting coated film is presented in Table 3. The resulting double coated polypropylene substrate is now both hydrophobic and oleophobic.

**Table 3: Contact Angle analysis of polypropylene film coated with i) polyacrylic acid and ii) poly(heptadecafluorodecylacrylate)**

| **Probe Liquid** | ***Θ (left)*** | ***Θ (right)*** |
|---|---|---|
| Water | 104.57 | 104.89 |
| Water | 104.13 | 103.56 |
| Water | 99.99 | 102.02 |
| Hexadecane | 62.25 | 58.90 |
| Hexadecane | 56.97 | 54.66 |
| Hexadecane | 59.26 | 59.77 |

## Claims

1. An atmospheric pressure plasma assembly (1) comprising a first and second pair of vertically arrayed, parallel spaced-apart planar electrodes (36) with at least a first dielectric plate (31) between said first pair, adjacent a first electrode of the first pair, and at least a first dielectric plate (31) between said second pair, adjacent a first electrode of the second pair, wherein the spacing between the first dielectric plate of the first pair of electrodes and another dielectric plate between said first pair of electrodes or the spaced apart electrode of the first pair of electrodes forms a first plasma region (25) and the spacing between the first dielectric plate of the second pair of electrodes and another dielectric plate between said second pair of electrodes or the spaced apart electrode of the second pair of electrodes forms a second plasma region (60) wherein the assembly further comprises a means of transporting a substate (70,71,72) successively through said first and second plasma regions (25,60), **characterised in that** the assembly further comprises an atomiser (74) adapted to introduce an atomised liquid or solid coating making material into one of said first or second plasma regions.

2. An assembly in accordance with claim 1 wherein the substrate is transported through said first and second plasma regions by means of guide rollers and/or guide reels (70, 71, 72).

3. An assembly in accordance with any preceding claim wherein each electrode is comprised by an electrode unit containing the electrode (36), an adjacent dielectric plate (31) and a cooling liquid distribution system (20,26) for directing a cooling conductive liquid onto the exterior of the electrode (36) to cover a planar face of the electrode (36).

4. An assembly in accordance with claim 3 wherein the cooling conductive liquid is water.

5. An assembly in accordance with claim 3 or 4 wherein the electrode unit is in the form of a watertight box (20, 20a, 26) having a side formed by a dielectric plate (31) having bonded thereto, on the interior of the box (20,20a, 26), a planar electrode (36) together with a liquid inlet (14) and a liquid outlet (15).

6. An assembly in accordance with any preceding claim retained in an outer casing in which a lid (76) is provided to prevent escape of a process gas which is required in order to activate the plasma.

7. An assembly in accordance with any preceding claim wherein the atomizer (74) is an ultrasonic nozzle.

8. An assembly in accordance with any preceding claim wherein the electrode (36) is a dielectric with a metallic coating.

9. An assembly in accordance with any preceding claim wherein said assembly is an atmospheric pressure glow discharge assembly.

10. An assembly in accordance with any preceding claim adapted for preparing multilayer coatings upon flexible substrates wherein plasma is generated between vertically orientated electrodes (36), which are arranged in series and adapted to enable single pass, multiple treatment or multilayer coatings.

11. An assembly in accordance with any preceding claim **characterised in that** the assembly comprises one or more additional pairs of vertically orientated electrodes (36) situated before or after said first and second pair of electrodes.

12. A method of atmospheric plasma treating a substrate with an atmospheric pressure plasma assembly (1) in accordance with any preceding claim comprising passing a substrate successively through the first and second plasma regions of the atmospheric pressure plasma assemby in accordance with any of claims 1-11 (25,60) and introducing an atomised liquid or solid coating making material from an atomiser (74) into one of said first or second plasma regions.

13. A method in accordance with claim 12 wherein the atomised solid or liquid coating making material is transferred from the atomiser (74) into the plasma region (60) by means of gravitational feed.

14. A method in accordance with claim 12 or 13 wherein the atomised solid or liquid coating material is introduced into the plasma region in the absence of a carrier gas.

15. A method in accordance with claim 12, 13 or 14 wherein the substrate comprises plastics, metallic thin films, synthetic and/or natural fibres, woven or non-woven fibres, siloxane, fabrics, cellulosic material or a blend of an organic polymeric material and an organosilicon-containing additive.

16. A method of atmospheric plasma treating a substrate in accordance with any one of claims 12. 13. 14 or 15 comprising, transporting a substrate through an atmospheric pressure plasma assembly in accordance with any one of claims 1 to 11 upwardly through one plasma region (25,60) and downwardly though the other plasma region (25,60).

17. A method in accordance with any one of claims 12 to 16 wherein the first plasma region (25) through which the substrate passes contains a cleaning plasma and the second plasma region (60) through which the substrate passes effects a coating on the substrate by means of the atomised liquid or solid coating forming material.

18. A method in accordance with any one of claims 12 to 17 wherein, in use, the temperature of the assembly is maintained in the range of from room temperature to 70° C.

## Patentansprüche

1. Plasmaanordnung (1) unter atmosphärischem Druck, umfassend ein erstes und ein zweites Paar vertikal angeordneter, parallel in einem Abstand voneinander angebrachter planarer Elektroden (36) mit wenigstens einer ersten dielektischen Platte (31) zwischen dem ersten Paar, angrenzend an eine erste Elektrode des ersten Paares, und wenigstens einer ersten dielektrischen Platte (31) zwischen dem zweiten Paar, angrenzend an eine erste Elektrode des zweiten Paars, wobei der Raum zwischen der ersten dielektrischen Platte des ersten Paars der Elektroden und einer weiteren dielektrischen Platte zwischen dem ersten Paar der Elektroden oder der räumlich entfernten Elektrode des ersten Paars der Elektroden eine erste Plasmaregion (25) bildet und der Raum zwischen der ersten dielektrischen Platte des zweiten Paars der Elektroden und einer weiteren dielektrischen Platte zwischen dem zweiten Paar der Elektroden oder der räumlich entfernten Elektrode des zweiten Paars von Elektroden eine zweite Plasmaregion (60) bildet, wobei die Anordnung außerdem eine Einrichtung zum Transportieren eines Substrats (70, 71, 72) nacheinander durch die erste und zweite Plasmaregion (25,60) umfasst, **dadurch gekennzeichnet, dass** die Anordnung außerdem einen Zerstäuber (74) enthält, der angepasst ist, um ein atomisiertes flüssiges oder festes schichtbildendes Material in eine der beiden ersten oder zweiten Plasmaregionen einzubringen.

2. Anordnung in Übereinstimmung mit Anspruch 1, wobei das Substrat durch die erste und zweite Plasmaregion mit Hilfe von Führungswalzen und/oder Führungsrollen (70, 71, 72) transportiert wird.

3. Anordnung in Übereinstimmung mit einem der vorhergehenden Ansprüche, wobei jede Elektrode von einer Elektrodeneinheit umfasst ist, die die Elektrode (36), eine angrenzende dielektrische Platte (31) und ein Kühlflüssigkeitsverteilungssystem (20, 26) zum Lenken einer leitenden Kühlflüssigkeit auf die Außenseite der Elektrode (36), um eine planare Oberfläche der Elektrode (36) zu bedecken, umfasst.

4. Anordnung in Übereinstimmung mit Anspruch 3, wobei die leitende Kühlflüssigkeit Wasser ist.

5. Anordnung in Übereinstimmung mit Anspruch 3 oder 4, wobei die Elektrodeneinheit in Form einer wasserdichten Box (20, 20a ,26) ausgebildet ist, mit einer von einer dielektrischen Platte (31) gebildeten Seite, mit der auf der Innenseite der Box (20, 20a, 26) eine planare Elektrode (36) zusammen mit einem Flüssigkeitseinlass (14) und einem Flüssigkeitsauslass (15) verbunden ist.

6. Anordnung in Übereinstimmung mit einem der vorhergehenden Ansprüche, gehalten in einem äußeren Gehäuse, in dem eine Klappe (76) vorgesehen ist, um das Entweichen eines Prozessgases zu verhindern, welches erforderlich ist, um das Plasma zu aktivieren.

7. Anordnung in Übereinstimmung mit irgendeinem der vorhergehenden Ansprüche, wobei der Zerstäuber (74) eine Ultraschalldüse ist.

8. Anordnung in Übereinstimmung mit einem der vorhergehenden Ansprüche, wobei die Elektrode (36) ein Dielektrikum mit einer metallischen Beschichtung ist.

9. Anordnung in Übereinstimmung mit einem der vorhergehenden Ansprüche, wobei diese Anordnung eine Anordnung zur Glimmentladung bei atmosphärischem Druck ist.

10. Anordnung in Übereinstimmung mit einem der vorhergehenden Ansprüche, angepasst zur Herstellung von mehrlagigen Beschichtungen auf flexiblen Substraten, wobei das Plasma zwischen vertikal orientierten Elektroden (36) erzeugt wird, die in Serie angeordnet sind und angepasst sind, um in einem Durchlauf eine mehrfache Behandlung oder mehrlagige Beschichtungen zu ermöglichen.

11. Anordnung in Übereinstimmung mit einem der vorhergehenden Ansprüche, **dadurch gekennzeichnet, dass** die Anordnung eine oder mehrere zusätzliche Paare vertikal orientierter Elektroden (36) umfasst, die vor oder nach dem ersten und zweiten Paar der Elektroden angeordnet sind.

12. Verfahren zum Behandeln eines Substrats mit atmosphärischem Plasma mit einer Plasmaanordnung (1) unter atmosphärischem Druck in Übereinstimmung mit einem der vorhergehenden Ansprüche, umfassend das nacheinanderfolgende Hindurchführen eines Substrats durch die erste und die zweite Plasamaregion (25, 60) der Plasmaanordnung unter atmosphärischem Druck in Übereinstimmung mit einem der Ansprüche 1-11 und Einführen eines atomisierten flüssigen oder festen schichtbildenden Materials aus einem Zerstäuber (74) in eine der ersten oder zweiten Plasmaregionen.

13. Verfahren in Übereinstimmung mit Anspruch 12, wobei das atomisierte feste oder flüssige schichtbildende Material von dem Zerstäuber (74) in die Plasmaregion (60) mit Hilfe der Schwerkraft überführt wird.

14. Verfahren in Übereinstimmung mit Anspruch 12 oder 13, wobei das atomisierte feste oder flüssige Beschichtungsmaterial in die Plasmaregion in Abwesenheit eines Trägergases eingeführt wird.

15. Verfahren in Übereinstimmung mit Anspruch 12, 13 oder 14, wobei das Substrat Plastik, dünne metallische Filme, synthetische und/oder natürliche Fasern, gewebte oder nicht gewebte Fasern, Siloxane, Textilerzeugnisse, Cellulosematerial oder ein Gemisch eines organischen polymeren Materials und eines Organosilicium enthaltenden Additivs umfasst.

16. Verfahren zum Behandeln eines Substrat mit atmosphärischem Plasma in Übereinstimmung mit einem der Ansprüche 12, 13, 14 oder 15, umfassend das Transportieren eine Substrats durch eine Plasmaanordnung unter atmosphärischem Druck in Übereinstimmung mit einem der Ansprüche 1-11 aufwärts durch eine Plasmaregion (25,60) und abwärts durch die andere Plasmaregion (25,60).

17. Verfahren in Übereinstimmung mit einem der Ansprüche 12-16, wobei die erste Plasmaregion (25), durch die das Substtrat hindurchläuft, ein reinigendes Plasma enthält, und die zweite Plasmaregion (60), durch die das Substrat hindurchläuft, eine Beschichtung auf dem Substrat mit Hilfe des atomisierten flüssigen oder festen schichtbildenden Materials bewirkt.

18. Verfahren in Übereinstimmung mit einem der Ansprüche 12-17, wobei die Temperatur der Anordnung während des Betriebes in dem Bereich von Raumtemperatur bis 70°C aufrechterhalten wird.

## Revendications

1. Ensemble de production de plasma à pression atmosphérique (1) comprenant une première et une seconde paires d'électrodes planes parallèles (36) disposées verticalement en réseau, espacées avec un écart, avec au moins une première plaque diélectrique (31) entre ladite première paire, adjacente à une première électrode de la première paire, et au moins une première plaque diélectrique (31) entre ladite seconde paire, adjacente à une première électrode de la seconde paire, dans lequel l'espacement entre la première plaque diélectrique de la première paire d'électrodes et une autre plaque diélectrique entre ladite première paire d'électrode ou l'électrode espacée avec un écart, de la première paire d'électrodes, forme une première région de plasma (25) et l'espacement entre la première plaque diélectrique de la seconde parie d'électrodes et une autre plaque diélectrique entre ladite seconde paire d'électrodes ou l'électrode espacée avec un écart, de la seconde paire d'électrodes, forme une seconde région de plasma (60), dans lequel l'ensemble comprend également un moyen de transport d'un support (70, 71, 72) successivement à travers lesdites première et seconde régions de plasma (25, 60), **caractérisé en ce que** l'ensemble comprend également un atomiseur (74) adapté de façon à introduire un matériau liquide ou solide atomisé constituant un revêtement dans l'une desdites première ou seconde régions de plasma.

2. Ensemble selon la revendication 1, dans lequel le support est transporté à travers lesdites première et seconde régions de plasma au moyen de rouleaux de guidage et/ou de bobines de guidage (70, 71, 72).

3. Ensemble selon l'une quelconque des revendications précédentes, dans lequel chaque électrode est composée d'une unité d'électrode contenant l'électrode (36), d'une plaque diélectrique adjacente (31) et d'un système de distribution de liquide de refroidissement (20, 26) pour amener un liquide de refroidissement par conduction sur l'extérieur de l'électrode (36) pour recouvrir une face plane de l'électrode (36).

4. Ensemble selon la revendication 3, dans lequel le liquide de refroidissement par conduction est de l'eau.

5. Ensemble selon la revendication 3 ou 4, dans lequel l'unité d'électrode est sous forme d'une boîte étanche à l'eau (20, 20a, 26) comportant une face formée par une plaque diélectrique (31) sur laquelle sont collées, sur l'intérieur de la boîte (20, 20a, 26), une électrode plane (36) ainsi qu'une entrée de liquide (14) et une sortie de liquide (15).

6. Ensemble selon l'une quelconque des revendications précédentes, logé dans un boîtier extérieur dans lequel on prévoit un couvercle (76) pour empêcher l'échappement d'un gaz industriel qui est requis pour activer le plasma.

7. Ensemble selon l'une quelconque des revendications précédentes, dans lequel l'atomiseur (74) est une buse à ultrasons.

8. Ensemble selon l'une quelconque des revendications précédentes, dans lequel l'électrode (36) est un diélectrique avec un revêtement métallique.

9. Ensemble selon l'une quelconque des revendications précédentes, dans lequel ledit ensemble est un ensemble à décharge luminescente à pression atmosphérique.

10. Ensemble selon l'une quelconque des revendications précédentes, adapté pour préparer des revêtements multicouches sur des supports flexibles, dans lequel le plasma est produit entre des électrodes orientées verticalement (36), qui sont disposées en série et adaptées pour permettre des revêtements à une seule passe, à traitement multiple ou multicouches.

11. Ensemble selon l'une quelconque des revendications précédentes, **caractérisé en ce que** l'ensemble comprend une ou plusieurs paires supplémentaires d'électrodes orientées verticalement (36), situées avant ou après lesdites première et seconde paires d'électrodes.

12. Procédé de traitement, par plasma à pression atmosphérique, d'un support avec un ensemble de production de plasma à pression atmosphérique (1) selon l'une quelconque des revendications précédentes, consistant à faire passer un support successivement à travers la première et la seconde région de plasma (25, 60) de l'ensemble de production de plasma à pression atmosphérique selon l'une quelconque des revendications 1 à 11, et à introduire un matériau liquide ou solide atomisé constituant un revêtement, provenant d'un atomiseur (74), dans l'une desdites première ou seconde régions de plasma.

13. Procédé selon la revendication 12, dans lequel le matériau liquide ou solide atomisé constituant un revêtement est transféré de l'atomiseur (74) dans la région de plasma (60) au moyen d'une alimentation par gravité.

14. Procédé selon la revendication 12 ou 13, dans lequel le matériau liquide ou solide atomisé constituant un revêtement est introduit dans la région de plasma en l'absence d'un gaz porteur.

15. Procédé selon la revendication 12, 13 ou 14, dans lequel le support comprend du plastique, des films métalliques minces, des fibres synthétiques et/ou naturelles, des fibres tissées ou non tissées, du siloxane, du tissu, du matériau cellulosique ou un mélange d'un matériau polymère organique et d'un additif contenant un organosilicone.

16. Procédé de traitement, par plasma à pression atmosphérique, d'un support selon l'une quelconque des revendications 12, 13, 14 ou 15, consistant à transporter un support à travers un ensemble de production de plasma à pression atmosphérique selon l'une quelconque des revendications 1 à 11 vers le haut à travers une région de plasma (25, 60) et vers le bas à travers l'autre région de plasma (25, 60).

17. Procédé selon l'une quelconque des revendications 12 à 16, dans lequel la première région de plasma (25) à travers laquelle le support passe contient un plasma de nettoyage et la seconde région de plasma (60) à travers laquelle le support passe réalise un revêtement sur le support au moyen du matériau liquide ou solide atomisé constituant un revêtement.

18. Procédé selon l'une quelconque des revendications 12 à 17, dans lequel, en service, la température de l'ensemble est maintenue dans la gamme de la température ambiante à 70°C.
